# EUROPÄISCHE PATENTANMELDUNG

(11) **EP 4 016 655 A1**
(43) Veröffentlichungstag der Anmeldung: **22.06.2022**
(21) Anmeldenummer: 20214817.7
(22) Anmeldetag: 17.12.2020
(51) Int. Cl.: H01L 51/00, H05K 3/12, H05K 3/46

(54) **VERFAHREN UND ANLAGE ZUM HERSTELLEN VON ELEKTRONISCHEN BAUGRUPPEN MIT EINER DRUCKVORRICHTUNG**

(71) Anmelder: Siemens Aktiengesellschaft, 80333 München (DE)
(72) Erfinder: Blank, Rene, 12249 Berlin (DE); Borwieck, Carsten, 14052 Berlin (DE); Franke, Martin, 14089 Berlin (DE); Frühauf, Peter, 14612 Falkensee (DE); Heimann, Matthias, 14469 Potsdam (DE); Knofe, Rüdiger, 14513 Teltow (DE); Müller, Bernd, 16259 Falkenberg (DE); Nerreter, Stefan, 15754 Heidesee OT Blossin (DE); Wittreich, Ulrich, 16727 Velten (DE)

(57) **Zusammenfassung**

Es wird ein Verfahren zum Herstellen von elektronischen Baugruppen (10) angegeben, welches die folgenden Schritte umfasst:
a) strukturiertes Auftragen eines fluiden Druckmediums (160) mittels einer Druckvorrichtung (100),
- wobei Schritt a) in einer sequenziellen Abfolge von einzelnen Druckschritten aᵢ) mehrfach hintereinander durchgeführt wird,

b) Messung wenigstens einer rheologischen Eigenschaft des Druckmediums (160) innerhalb der Druckvorrichtung (100),
- wobei Schritt b) in einer wiederholten Abfolge von einzelnen Messschritten bₙ) während der einzelnen Druckschritte aᵢ) und/oder zwischen den einzelnen Druckschritten aᵢ) durchgeführt wird,

c) Bereitstellen eines rheologischen Modells (M) für den Ablauf der einzelnen Druckschritte aᵢ),
- wobei das rheologische Modell (M) die wiederholt gemessene rheologische Eigenschaft als variablen Eingangsparameter nutzt,

d) Ermitteln eines günstigen Wertes für wenigstens einen ausgewählten Druckparameter mit Hilfe des rheologischen Modells (M) in Abhängigkeit von der aktuell gemessenen rheologischen Eigenschaft und
e) automatisiertes Einstellen des ermittelten günstigen Wertes für den wenigstens einen ausgewählten Druckparameter.

Weiterhin wird eine Fertigungsanlage beschrieben, welche zur Durchführung dieses Verfahrens ausgelegt ist.

## Beschreibung

Die vorliegende Erfindung betrifft ein Verfahren zum Herstellen von elektronischen Baugruppen, bei dem mit einer Druckvorrichtung ein fluides Druckmedium strukturiert aufgetragen wird. Weiterhin betrifft die Erfindung eine Fertigungsanlage, welche zur Durchführung dieses Verfahrens ausgelegt ist.

Aus dem Stand der Technik sind Fertigungsverfahren für elektronische Baugruppen bekannt, bei denen einzelne Materialschichten durch eine Druckvorrichtung aufgebracht werden. Besonders häufig werden in diesem Zusammenhang fluidische Werkstoffe wie z.B. Lotwerkstoffe bzw. Sinterwerkstoffe gedruckt, um aus ihnen elektrisch leitende Verbindungen zwischen den einzelnen funktionalen Bauelementen und den Leiterbahnen eines elektrischen Schaltungsträgers herzustellen. Hierzu werden z.B. Lotpasten bzw. Sinterpasten gemäß einem vordefinierten Layout auf ein Substrat aufgebracht. In ähnlicher Weise können auch andere funktionale Schichten wie zum Beispiel Klebemittel, Vergussmittel oder Füllmittel im Rahmen der Elektronik-Fertigung auf ein Trägersubstrat strukturiert aufgebracht werden. Die elektronischen Baugruppen werden dabei meist in Serienfertigung hergestellt, sodass also eine Vielzahl von untereinander gleichen oder ähnlichen Baugruppen in einer automatisierten Fertigungsanlage hintereinander prozessiert werden. Für den beschriebenen Druckprozess bedeutet dies, dass von der Druckvorrichtung eine Vielzahl von einzelnen Druckschritten sequenziell nacheinander durchgeführt wird.

Ein Problem bei diesen bekannten Fertigungsverfahren ist, dass das vordefinierte Layout, also die Ziel-Struktur für den Druck, in der Praxis nicht exakt eingehalten werden kann. Vielmehr ergeben sich für die einzelnen Druckschritte mehr oder weniger geringe Abweichungen von der Ziel-Struktur. Insbesondere bei einer Vielzahl von hintereinander ausgeführten Druckschritten können sich durch Variationen in äußeren Parametern (wie beispielsweise der Temperatur oder der Feuchtigkeit der Umgebungsluft) Schwankungen im rheologischen Verhalten des Druckmediums ergeben, welche wiederum zu Schwankungen in der Qualität des Druckerzeugnisses führen können. So kann sich selbst bei einer optimierten Einstellung der Druckparameter zu Beginn einer Fertigungsschicht im Laufe der Zeit ein Wegdriften von dem optimalen Parametersatz ergeben. Und selbst wenn die äußeren Parameter konstant sind oder nur sehr geringen Schwankungen unterliegen, kann es schwierig sein, unter den jeweils vorliegenden apparativen Randbedingungen und für das jeweils vorliegende Ziel-Layout den günstigsten Parametersatz zu finden.

Aufgabe der Erfindung ist es daher, ein Verfahren zur Herstellung von elektronischen Baugruppen anzugeben, welches die genannten Nachteile überwindet. Insbesondere soll ein Verfahren zur Verfügung gestellt werden, bei welchem günstige Werte für einen oder mehrere Druckparameter auf einfache Weise auffindbar sind. Insbesondere soll dabei auch eine einfache, automatisierte Anpassung dieses Druckparameters während des Betriebs der Fertigungsanlage möglich sein. Eine weitere Aufgabe ist es, eine Fertigungsanlage zur Verfügung zu stellen, welche zur Durchführung eines solchen Verfahrens ausgelegt ist.

Diese Aufgaben werden durch das in Anspruch 1 beschriebene Verfahren und die in Anspruch 15 beschriebene Fertigungsanlage gelöst.

Das erfindungsgemäße Verfahren dient der Herstellung von elektronischen Baugruppen und umfasst die folgenden Schritte:
a) strukturiertes Auftragen eines fluiden Druckmediums mittels einer Druckvorrichtung,
   - wobei Schritt a) in einer sequenziellen Abfolge von einzelnen Druckschritten aᵢ) mehrfach hintereinander durchgeführt wird,
b) Messung wenigstens einer rheologischen Eigenschaft des Druckmediums innerhalb der Druckvorrichtung,
   - wobei Schritt b) in einer wiederholten Abfolge von einzelnen Messschritten bₙ) während der einzelnen Druckschritte aᵢ) und/oder zwischen den einzelnen Druckschritten aᵢ) durchgeführt wird,
c) Bereitstellen eines rheologischen Modells für den Ablauf der einzelnen Druckschritte aᵢ),
   - wobei das rheologische Modell die wiederholt gemessene rheologische Eigenschaft als variablen Eingangsparameter nutzt,
d) Ermitteln eines günstigen Wertes für wenigstens einen ausgewählten Druckparameter mit Hilfe des rheologischen Modells in Abhängigkeit von der aktuell gemessenen rheologischen Eigenschaft und
e) automatisiertes Einstellen des ermittelten günstigen Wertes für den wenigstens einen ausgewählten Druckparameter.

Beim Schritt a) handelt es sich also um den eigentlichen Druckschritt, bei dem die strukturierte Auftragung des Druckmediums erfolgt. Bei der automatisierten Serienfertigung von einer Vielzahl von elektronischen Baugruppen wird dieser Schritt a) in einer sequenziellen Abfolge mehrfach wiederholt, so dass ich eine Folge von einzelnen Druckschritten aᵢ) ergibt. Beispielsweise können nacheinander mehrere Substrate bedruckt werden, so dass der Index i als Index des jeweils aktuellen Substrats verstanden werden kann. Aus jedem zu bedruckenden Substrat kann beispielsweise eine elektronische Baugruppe gefertigt werden. Die sequenzielle Abfolge der einzelnen Druckschritte aᵢ) kann insbesondere in einem gleichmäßigen, konstanten Prozesstakt erfolgen.

In ähnlicher Weise wird die Messung der rheologischen Eigenschaft in Schritt b) während der automatisierten SerienFertigung mehrfach wiederholt. Es soll sich hierbei um eine sogenannte "Inline-Messung" handeln, welche innerhalb der Fertigungsanlage und während der Serienfertigung durchgeführt wird. Insbesondere kann die Häufigkeit, mit der die einzelnen Messschritte bₙ) durchgeführt werden, von dem Prozesstakt der einzelnen Druckschritte abgeleitet sein. Beispielsweise können für jeden Druckschritt aᵢ) eine oder mehrere Messungen durchgeführt werden. Dies ist jedoch nicht zwingend nötig und es kann auch ausreichend sein, wenn nur hin und wieder, also beispielsweise nach einer festen Anzahl von einzelnen Druckschritten ein erneuter Messschritt erfolgt. Zweckmäßig ist es aber, wenn auch die Messschritte in einem gleichmäßigen und konstanten Takt durchgeführt werden und der Takt (also auch die Frequenz) der Messschritte mit dem Takt der Druckschritte in einem festen ganzzahligen Verhältnis steht. Die Durchführung der einzelnen Messschritte bₙ) kann dabei grundsätzlich während des Druckschritte oder zwischen den Druckschritten erfolgen. Es ist auch beides möglich, so dass insbesondere die rheologische Eigenschaft kontinuierlich gemessen werden kann.

Wesentlich im Zusammenhang mit der vorliegenden Erfindung ist, dass die gemessene rheologische Eigenschaft als Eingangsparameter für ein rheologisches Modell dient, mit welchem der Ablauf der einzelnen Druckschritte modelliert wird. Allgemein wird mit dem rheologischen Modell für den jeweiligen Wert der rheologischen Eigenschaft eine Abhängigkeit einer Zielgröße von einem ausgewählten Druckparameter modelliert. Auf diese Weise wird erreicht, dass aus dem rheologischen Modell ein günstiger Wert für den ausgewählten Druckparameter ermittelt werden kann, indem nämlich der von dem Modell prognostizierte Wert für die Zielgröße (gegebenenfalls unter Berücksichtigung relevanter Randbedingungen) optimiert wird. Es wird also mit Hilfe des Modells insbesondere ein optimierter Wert für den ausgewählten Druckparameter erhalten.

Das rheologische Modell kann grundsätzlich in seiner Komplexität sehr unterschiedlich ausgeprägt sein. Bei einer sehr einfachen Ausführungsform des Modells wird nur eine Kennlinie oder ein Kennfeld zur Verfügung gestellt, welche(s) für den aktuellen Wert der rheologischen Eigenschaft (und gegebenenfalls weiteren Eingangsparametern) die prognostizierte Abhängigkeit der Zielgröße von dem wenigstens einen ausgewählten Druckparameter wiedergibt. Alternativ kann es sich aber auch um ein komplexeres physikalisches Systemmodell handeln, mit welchem der Einfluss einer Vielzahl von Parametern simuliert wird. Das rheologische Modell kann auch mit einer Methode der künstlichen Intelligenz implementiert sein und insbesondere ein neuronales Netz aufweisen, welches durch maschinelles Lernen mit Hilfe von Trainingsdaten trainiert werden kann.

Der Vorteil des erfindungsgemäßen Verfahrens liegt allgemein darin, dass durch die Kombination der Inline-Messung einer rheologischen Eigenschaft und die Nutzung eines rheologischen Modells ein günstiger Wert für wenigstens einen Druckparameter ermittelt werden kann. Der auf diese Weise ermittelte günstige Wert kann dann in Schritt e) automatisiert als Druckparameter für die jeweils folgende Prozesszeit übernommen werden. Auf diese Weise kann eine einfache und automatisierte Optimierung von einem oder auch mehreren Druckparametern erfolgen. Insbesondere kann diese Optimierung kontinuierlich erfolgen, so dass auch bei einer zeitlichen Änderung von Prozessparametern (beispielsweise einer Veränderung in Temperatur bzw. Feuchtigkeit oder auch einer Umstellung des Drucklayouts) eine Nachregelung des Druckparameters möglich ist. Auf diese Weise kann auch bei Veränderungen während einer Fertigungsschicht ein automatisiertes Nachführen der Einstellungen erfolgen. So wird eine anhaltend hohe Qualität des Druckergebnisses erreicht und es werden Stillstandzeiten vermieden, welche bei einer rein manuellen Anpassung unter Umständen zur Neu-Auslegung der relevanten Druckparameter nötig wären, wenn stärkere Prozessschwankungen auftreten. Insgesamt kann damit also auch ein erhöhter Durchsatz der herzustellenden elektronischen Baugruppen bei anhaltend hoher Prozessqualität erreicht werden.

Die erfindungsgemäße Fertigungsanlage dient zur Herstellung von elektronischen Baugruppen und ist zur Durchführung des erfindungsgemäßen Verfahrens ausgelegt. Hierzu weist sie die in Anspruch 15 beschriebenen Merkmale auf. Die Vorteile der erfindungsgemäßen Fertigungsanlage ergeben sich analog zu den vorab beschriebenen Vorteilen des erfindungsgemäßen Verfahrens.

Vorteilhafte Ausgestaltungen und Weiterbildungen der Erfindung gehen aus den von Anspruch 1 abhängigen Ansprüchen sowie der folgenden Beschreibung hervor. Dabei können die beschriebenen Ausgestaltungen des Verfahrens und der Fertigungsanlage allgemein vorteilhaft miteinander kombiniert werden.

So kann es sich bei dem Verfahren insbesondere um ein automatisiertes Herstellungsverfahren handeln, bei dem die einzelnen Prozessschritte entweder vollständig oder zumindest so weitgehend automatisiert sind, dass nur in Ausnahmefällen (z.B. bei einer Störung) ein manuelles Eingreifen nötig ist.

Das Verfahren kann ein Verfahren zur Serienfertigung sein, bei welchem eine Serie von untereinander gleichen elektronischen Baugruppen nach demselben Layout hergestellt wird. Allerdings kann dabei von Zeit zu Zeit (z.B. innerhalb einer Fertigungsschicht) eine Umstellung auf eine andere Serie erfolgen, bei welcher die Layout-Parameter verändert sind. Hierdurch kann sich insbesondere bei den einzelnen Druckschritten aᵢ) eine gelegentliche Änderung von vorgegebenen Parameter wie Drucklayout und gegebenenfalls Schablonentyp und ähnlichem ergeben. Gerade auch bei einer solchen Prozessumstellung auf eine andere Serie oder Teilserie ermöglicht das erfindungsgemäße Verfahren eine einfache automatisierte Anpassung und Optimierung des wenigstens einen Druckparameters auf die neuen Gegebenheiten.

So kann allgemein bei der sequenziellen Abfolge von einzelnen Druckschritten aᵢ) eine Abfolge von mehreren einzelnen Substraten bedruckt werden. Mit anderen Worten handelt es sich dann um ein Verfahren der Serienfertigung, bei der eine Serie von mehreren Einzelsubstraten nacheinander bedruckt wird, um so eine entsprechende Serie von Baugruppen nacheinander herstellen zu können. Alternativ zu einer solchen sequenziellen Bestückung der Druckvorrichtung mit Einzelsubstraten kann prinzipiell aber auch eine Serienfertigung von mehreren Baugruppen dadurch erfolgen, dass ein langes Substrat bedruckt wird, indem sequenziell mehrere aufeinanderfolgende Druckflächen auf demselben zusammenhängenden Substrat bedruckt werden und diese einzelnen Druckflächen erst nach dem Druckprozess in Teilsubstrate vereinzelt werden. Eine solche Serienfertigung mit einem zusammenhängenden Substrat ist insbesondere bei flexiblen Substraten zweckmäßig, bei denen ein Rolle-zu-Rolle-Prozess durchgeführt werden kann.

Im Zusammenhang mit der Fertigung elektronischer Baugruppen ist es besonders bevorzugt, wenn die einzelnen Substrate elektrische Schaltungsträger sind. Durch das Bedrucken dieser Schaltungsträger mit strukturierten funktionellen Schichten kann auf einfache Weise ein Teilschritt der Serienfertigung solcher Baugruppen umgesetzt werden, bei denen ein solcher Schaltungsträger das grundlegende, mechanisch tragende Element ist, auf dem dann kleinere Teilelemente der Baugruppe platziert werden. Allgemein kann es sich bei einem solchen Schaltungsträger um einen organischen und/oder einen anorganischen Schaltungsträger handeln. Als Beispiel für einen Schaltungsträger aus (zumindest teilweise) organischem Material seinen hier gängige Leiterplatten genannt, welche insbesondere Kunststoffschichten enthalten können. Als anorganische Schaltungsträger können beispielsweise keramische Substrate dienen.

Bei dem fluiden Druckmedium kann es sich insbesondere um eine Paste handeln. Es kann sich also mit anderen Worten um eine Suspension eines Feststoffs in einer Flüssigkeit handeln, welche durch den Feststoffgehalt zähflüssig ist. Beim Druck einer solchen Paste kommen die Vorteile der Erfindung besonders gut zum Tragen, da hier die optimalen Druckparameter besonders empfindlich von den rheologischen Eigenschaften des Druckmediums abhängen. Diese rheologischen Eigenschaften können auch zeitlich veränderlich sein. Beispielsweise kann es sich bei der Paste um eine Lotpaste oder eine Sinterpaste handeln. Eine Lotpaste enthält metallische Lotpartikel als Suspension in einem flüssigen Bindemittel. Durch einen auf den Druckschritt nachfolgenden thermischen Lötschritt können die Lotpartikel zum Schmelzen gebracht werden, um eine elektrische und/oder mechanische Verbindung mittels der Lotpastenschicht herzustellen. In ähnlicher Weise enthält eine Sinterpaste metallische Sinterpartikel als Suspension in einem flüssigen Bindemittel. Durch einen nachfolgenden thermischen und/oder mechanischen Sinterschritt können die Sinterpartikel zu einem festen Verbund zusammengebacken werden, wodurch ebenfalls eine elektrische und mechanische Verbindung gebildet wird.

Alternativ kann es sich bei dem Druckmedium aber auch um ein Vergussmittel, ein Füllmittel und/oder ein Klebemittel für die elektronische Baugruppe handeln. Diese Druckmedien können insbesondere polymere Bestandteile aufweisen. Als Vergussmittel kann beispielsweise ein Vergussharz zum Einsatz kommen, mit dem elektronische Komponenten eingekapselt werden können. In ähnlicher Weise kann ein Füllmittel dazu verwendet werden, um eine elektronische Komponente zu unterfüllen, um so eine thermisch stabile und gegebenenfalls elastische mechanische Anbindung an das Substrat zu bewirken. Man spricht dann auch von einem sogenannten "Underfill". In ähnlicher, verallgemeinerter Weise kann generell ein strukturiert aufgebrachtes Klebemittel dazu dienen, zwei oder mehr Teilelemente der elektronischen Baugruppe dauerhaft stoffschlüssig miteinander zu verbinden, um so eine mechanische Fixierung zu erreichen.

Allgemein und unabhängig von der spezifischen Funktion des Druckmediums kann dieses metallische Partikel und zusätzliches ein flüssiges Bindemittel aufweisen. Eine solche Zusammensetzung ist insbesondere bei den beschriebenen Lot- und Sinterpasten zweckmäßig. Die metallischen Partikel bewirken dabei die Funktionalität bei der Herstellung einer Lot- bzw. Sinterverbindung, und das flüssige Bindemittel ermöglicht die Fließ- bzw. Streichfähigkeit des Druckmediums. Das flüssige Bindemittel kann beispielsweise ein organisches Lösungsmittel oder Öl und/oder ein niedermolekulares organisches Harz enthalten. Optional kann zusätzlich ein Aktivator enthalten sein, welcher nach einer Aktivierung die Eigenschaften des Druckmediums verändert. So kann beispielsweise ein Flussmittel als Aktivator enthalten sein, welches erst nach einer thermischen Aktivierung die Benetzung des Substrats durch das Druckmedium erhöht.

Die Druckvorrichtung kann vorteilhaft ein Schablonendrucker, ein Siebdrucker, ein Tampondrucker oder ein Dispenser/Jetter sein. Schablonendruck und Siebdruck sind besonders gängige Verfahren, um in der Elektronikfertigung funktionale strukturierte Schichten aus Lot- oder Sinterpasten aufzubringen, aber auch andere Schichten wie z.B. Klebeschichten können vorteilhaft auf diese Weise aufgebracht werden. Dabei dient eine Druckschablone bzw. ein Drucksieb als strukturgebendes Element. Auch Tampondruck und Dispensen/Jetten können hier vorteilhaft eingesetzt werden, denn auch mit diesen Verfahren können funktionale Schichten mit einer definierten Struktur aufgetragen werden. Daher soll im Zusammenhang der vorliegenden Erfindung auch das Dispensen als Druckverfahren im weiteren Sinne verstanden werden. Auch hier kommen die Vorteile der Erfindung zum Tragen, da bei all den beispielhaft genannten Verfahren (sowie weiteren bekannten Druckverfahren) die Qualität des Druckergebnisses entscheidend von den rheologischen Eigenschaften des Druckmediums sowie ausgewählten Druckparametern abhängt.

Der wenigstens eine ausgewählte Druckparameter, für den in Schritt d) ein günstiger Wert ermittelt wird und der in Schritt e) automatisiert eingestellt wird, kann allgemein vorteilhaft eine Druckgeschwindigkeit bzw. eine Auslassgeschwindigkeit des Druckmediums, eine Druckkraft oder ein Abstand eines Druckkopfes zur Substratoberfläche sein. Bezogen auf die Verfahren des Schablonen- oder Siebdrucks kann dies insbesondere eine Rakelgeschwindigkeit, eine Rakelkraft oder ein Absprung sein. Im Rahmen der Erfindung soll zumindest ein solcher ausgewählter Druckparameter auf Grundlage des rheologischen Modells eingestellt werden. Es ist aber auch möglich und unter Umständen vorteilhaft, wenn für zwei oder mehr ausgewählte Parameter in Schritt d) ein günstiger Wert ermittelt und dieser in Schritt e) eingestellt wird. Auf diese Weise können besonders weitgehend optimierte Druckergebnisse erzielt werden.

Die in den einzelnen Messschritten bₙ) gemessene rheologische Eigenschaft kann bevorzugt eine Viskosität, eine Schubspannung, ein Verlustmodul und/oder ein Speichermodul sein. Diese rheologischen Eigenschaften sind grundsätzlich relativ leicht zu messen und sie haben einen vergleichsweise großen Einfluss darauf, mit welchen konkreten Druckparametern ein qualitativ gutes Druckergebnis erzielt werden kann. Insbesondere ist die während eines Druckschrittes bewirkte Benetzung des Substrates mit dem Druckmedium stark von diesen rheologischen Eigenschaften einerseits und von dem ausgewählten Druckparameter andererseits abhängig.

Gemäß einer allgemein vorteilhaften Ausführungsform kann die rheologische Eigenschaft mit einem in der Druckvorrichtung integrierten Prozessrheometer gemessen werden. Es soll sich also mit anderen Worten um ein Rheometer handeln, welches die rheologische Eigenschaft "in situ" innerhalb der Druckvorrichtung messen kann, so dass zur Durchführung der Messung keine Entnahme einer Probe aus der Anlage nötig ist. Als Beispiel für solche "Inline-Rheometer" seien hier die sogenannten Prozessviskosimeter genannt, welche in eine Rohrleitung oder in ein Vorratsgefäß integriert werden können und dort die Viskosität eines Betriebsmediums "in situ" messen können. Mögliche Orte für eine solche rheologische Inline-Messung sind beispielsweise ein Vorratsgefäß für das Druckmedium, eine Zuflussleitung des Druckmediums zu einem Druckkopf oder auch ein Ort im Bereich des Druckkopfes selbst. Diesen drei Varianten für das Verfahren entsprechen drei analoge Varianten der Fertigungsanlage, bei denen der rheologische Sensor entweder in ein Vorratsgefäß oder in eine Zuflussleitung oder in den Druckkopf integriert ist. Ein rheologischer Sensor in einem Vorratsgefäß kann beispielsweise durch einen Messrührer realisiert sein.

Gemäß einer allgemein besonders bevorzugten Ausführungsform des Verfahrens können die Schritte d) und e) jeweils mehrfach wiederholt werden. Mit anderen Worten wird dann der ermittelte günstige Wert für den ausgewählten Druckparameter nicht nur einmal eingestellt, sondern während der Serienfertigung der Baugruppen immer wieder auf die jeweils gegebenen Randbedingungen angepasst.

Die Ermittlung des "günstigen Wertes" in Schritt d) kann allgemein dadurch erfolgen, dass eine von dem Modell vorhergesagte Zielgröße optimiert wird oder zumindest in bestimmten Grenzen möglichst nahe an einen optimalen Wert angenähert wird. Diese modellierte Zielgröße kann allgemein eine Qualitäts-Kenngröße des Druckprozesses sein, insbesondere die Genauigkeit der Einhaltung einer vordefinierten zu bedruckenden Benetzungsfläche. Mit anderen Worten kann hier eine Konturtreue als Zielgröße herangezogen werden, wobei als Zielgröße einerseits die Einhaltung der Größe, aber andererseits vor allem auch der Form der vordefinierten Benetzungsfläche sein kann. Hierzu kann beispielsweise eine gemittelte Abweichung einer realen Druckkontur (also der Grenzlinie zwischen bedruckter und nicht bedruckter Fläche) und einer vordefinierten Soll-Kontur bestimmt und minimiert werden. Eine solche gemittelte Abweichung ist nicht auf einen arithmetischen Mittelwert beschränkt, sondern es kann auch eine gewichtete Mittelung beispielsweise über einen quadratischen Mittelwert ("root mean square") ermittelt und minimiert werden.

Bei der Optimierung kann, wie bereits beschrieben, entweder eine einfache Kennlinie oder ein Kennfeld zum Einsatz kommen oder auch ein komplexeres Modell mit einer Vielzahl von Abhängigkeiten bis hin zu einem selbstlernenden neuronalen Netz. Im letzteren Fall können insbesondere auch Messwerte für die Qualitäts-Kenngröße aus einer nachgelagerten Messung von tatsächlich durchgeführten Druckschritten als Teil eines Trainings-Datensatzes verwendet werden.

Allgemein und unabhängig von der genauen Implementierung des rheologischen Modells kann dieses zusätzlich zu der gemessenen rheologischen Eigenschaft ein oder mehrere weitere Eingangsparameter nutzen, beispielsweise eine Umgebungstemperatur und eine Feuchtigkeit der umgebenden Luft. Diese weiteren Parameter können insbesondere abhängig von während des Verfahrens "inline" durchgeführten Messungen laufend aktualisiert werden. Weitere Eingangsparameter, welche entweder über eine Fertigungsserie hinweg konstant sein können oder gegebenenfalls auch zumindest innerhalb einer Fertigungsschicht variiert werden können (also z.B. von Teil-Serie zu Teil-Serie) sind der Typ (also Material und/oder Geometrie) einer verwendeten Druckschablone, eines Drucksiebs und/oder einer Rakel. Bei der Druckschablone bzw. dem Drucksieb können z.B. die Größe, Anzahl und Dichte der einzelnen Drucköffnungen zwischen verschiedenen Teil-Serien variiert werden, was auch einen Einfluss auf das Druckergebnis hat und zu Anpassungen in dem ausgewählten Druckparameter führen kann.

Gemäß einer besonders bevorzugten Ausführungsform kann das in Schritt c) bereitgestellte rheologische Modell laufend angepasst werden, indem im Anschluss an die einzelnen Druckschritte aᵢ) jeweils eine Zielgröße für das Druckergebnis gemessen wird und mit der entsprechenden mit Hilfe des rheologischen Modells vorhergesagten Zielgröße verglichen wird. Es kann also insbesondere eine Mehrzahl von zusätzlichen Messschritten fᵢ) erfolgen, welche vorteilhaft in einer nachgelagerten Prozessvorrichtung durchgeführt werden. Bei dieser nachgelagerten Prozessvorrichtung kann es sich insbesondere um eine optische Inspektionsvorrichtung handeln, besonders bevorzugt um eine Lotpasteninspektionsvorrichtung. Der Vorteil dieser Ausführungsform liegt darin, dass eine anlageninterne Qualitätsüberwachung stattfindet und durch die zusätzlichen Messschritte eine geschlossene Regelschleife für das rheologische Modell geschaffen wird. Die zusätzlichen Messergebnisse werden zur Anpassung des Modells genutzt, was das Ergebnis dessen Vorhersage und die damit vorgenommene Optimierung des ausgewählten Druckparameters wesentlich verbessert. In diesem geschlossenen Regelkreislauf wird entsprechend auch eine Korrelation von Schwankungen in der rheologischen Messgröße bei den Messschritten bₙ) mit Schwankungen in der zusätzlichen Messgröße in den nachfolgenden Kontrollschritten fᵢ) berücksichtigt. Durch entsprechend optimierte Anpassung des ausgewählten Druckparameters werden insgesamt die Schwankungen in der erhaltenen Druckqualität möglichst gering gehalten. Bei der in den nachfolgenden Kontrollschritten fᵢ) gemessenen Ziel- oder Kenngröße kann es insbesondere wiederum um einen Benetzungswinkel oder um die Genauigkeit der Einhaltung einer vordefinierten Benetzungsfläche handeln. Die Anpassung des rheologischen Modells kann dabei grundsätzlich auf unterschiedliche Weise erfolgen: Bei einer ersten Variante können innerhalb des rheologischen Modells weitere physikalische Parameter angepasst werden. Dies können insbesondere solche physikalischen Parameter sein, welche Schwankungen unterliegen und/oder für welche keine exakten Messwerte bekannt sind. Auf diese Weise können Schwankungen in der Temperatur und/oder Feuchtigkeit zumindest näherungsweise über ihren Effekt auf die Druckqualität erfasst werden. Alternativ zu einer solchen reinen Parameter-Variation kann aber auch das Modell selbst verändert werden, also insbesondere die zugrundeliegende Berechnungsmethode. Dies kann insbesondere dann genutzt werden, wenn innerhalb des Modells eine Methode der künstlichen Intelligenz zum Einsatz kommt. So kann beispielsweise ein neuronales Netz mit gemessenen Daten aus den nachfolgenden Kontrollschritten fᵢ) im laufenden Prozess trainiert bzw. weiter optimiert werden.

Entsprechend der vorab beschriebenen Ausführungsform des Verfahrens kann auch die Fertigungsanlage eine der Druckvorrichtung nachgelagerte Inspektionsvorrichtung aufweisen, mit der die zusätzliche Messung in den nachfolgenden Kontrollschritten fᵢ) erfolgen kann. Dies kann insbesondere eine Lotpasteninspektionsvorrichtung sein.

Der Druckbereich der Druckvorrichtung kann insbesondere ein Drucktisch sein, welcher zur sequenziellen Aufnahme von mehreren Substraten ausgebildet ist. Die Druckvorrichtung kann optional ein strukturgebendes Element wie beispielsweise eine Druckschablone oder ein Drucksieb umfassen.

Die beschriebene Modellierungseinheit und die Auswerteeinheit der Fertigungsanlage müssen nicht Teil der Druckvorrichtung sein, aber sie können in diese integriert sein. Modellierungseinheit und Auswerteeinheit können in einer kombinierten Simulationseinheit zusammengefasst sein, welche insbesondere zur Durchführung einer computergestützten Modellierung und Auswertung ausgebildet ist. Die beschriebene Einstelleinheit ist zweckmäßig in die Druckvorrichtung integriert.

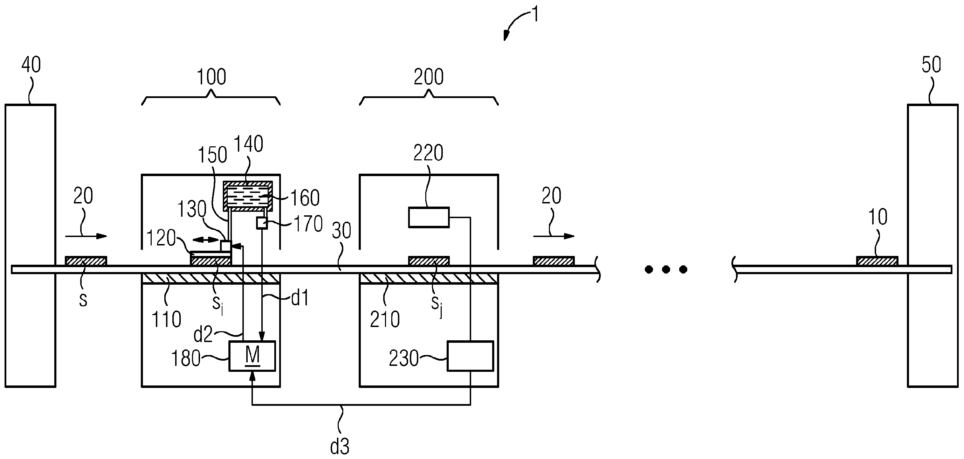

Nachfolgend wird die Erfindung anhand eines bevorzugten Ausführungsbeispiels unter Bezugnahme auf die angehängte Zeichnung beschrieben. So zeigt die einzige Figur 1 eine schematische Darstellung einer Fertigungsanlage 1, die zur Durchführung des erfindungsgemäßen Verfahrens ausgelegt ist.

Die Fertigungsanlage 1 dient der automatisierten Serienfertigung einer Vielzahl von elektronischen Baugruppen 10. Diese Baugruppen 10 werden hergestellt, indem eine Vielzahl von entsprechenden Substraten s entlang einer Prozessrichtung 20 durch die Anlage hindurch gefördert werden. Hierzu ist eine Fördereinrichtung 30 vorgesehen, welche die einzelnen Substrate s von einem Eingangsstapler 40 zu einem Ausgangsstapler 50 transportiert. Im Bereich des Eingangsstaplers 40 handelt es sich bei den Substraten noch um nackte elektrische Schaltungsträger. Im Bereich des Ausgangsstaplers handelt es sich dagegen um fertige elektronische Baugruppen 10, welche insbesondere mit einer Vielzahl von elektronischen Komponenten bestückt und elektrisch verbunden sein können.

Zwischen dem Eingangsstapler 40 und dem Ausgangsstapler 50 passieren die zu prozessierenden Substrate s eine Mehrzahl von Prozessvorrichtungen, von denen hier nur eine Druckvorrichtung 100 und eine optische Inspektionsvorrichtung 200 dargestellt sind. Im Anschluss an die Inspektionsvorrichtung 200 ist zweckmäßig noch eine Anzahl weiterer Prozessvorrichtungen angeordnet, die von dem Substrat durchlaufen werden. Da diese im Zusammenhang mit der vorliegenden Erfindung weniger relevant sind, werden sie hier nur zusammengefasst durch drei Punkt repräsentiert. Die Fertigungsanlage kann in diesem Bereich beispielsweise noch eine Bestückungsvorrichtung und eine Reflow-Lötanlage umfassen.

Innerhalb der Druckvorrichtung 100 wird auf den einzelnen Substraten s jeweils eine Schicht aus einem fluiden Druckmedium 160 strukturiert aufgebracht. Hierzu enthält die Druckvorrichtung 100 einen Vorratsbehälter 140 mit diesem Druckmedium. Das Druckmedium kann beispielsweise eine Lotpaste oder eine Sinterpaste sein. Bei der Druckvorrichtung 100 kann es sich beispielsweise um einen Schablonendrucker handeln.

Beim gezeigten Beispiel weist die Druckvorrichtung 100 einen Drucktisch 110 auf, auf welchem das jeweils zu bedruckende Substrat (hier sᵢ) während des aktuell durchzuführenden Druckschrittes aᵢ) angeordnet und prozessiert wird. Es werden also insbesondere mehrere solche Substrate in einer sequenziellen Abfolge von einzelnen Druckschritten aᵢ) strukturiert beschichtet. Beim vorliegenden Beispiel des Schablonendruckers wird die Struktur über eine Druckschablone 120 definiert, welche vor dem Druck auf das jeweilige Substrat aufgelegt wird. Dann wird das Druckmedium über einen Druckkopf 130 appliziert, welcher hier beispielsweise als geschlossene Rakelkopfeinheit ausgestaltet ist. Diese Druckeinheit wird über eine Zuflussleitung 150 aus dem Vorratsbehälter 140 mit dem Druckmedium 160 gespeist. Die horizontale Bewegung des Rakelkopfes 130 während des Druckvorgangs ist durch einen Doppelpfeil angedeutet.

Wesentlich im Zusammenhang mit der vorliegenden Erfindung ist, dass innerhalb der Druckvorrichtung 100 ein rheologischer Sensor 170 angeordnet ist. Es handelt sich insbesondere um ein integriertes Prozessrheometer, welches eine rheologische Eigenschaft des fluiden Druckmediums innerhalb der Druckvorrichtung 100 messen kann, ohne dass eine gesonderte Probenentnahme erforderlich ist. Im gezeigten Beispiel ist das Rheometer 170 im Bereich des Vorratsbehälters 140 angeordnet. Alternativ könnte es aber auch beispielsweise im Bereich der Zuleitung 150 oder im Bereich des Rakelkopfes 130 angeordnet sein.

Mit dem rheologischen Sensor 170 wird eine rheologische Eigenschaft des Druckmediums 160 (beispielsweise eine Viskosität) wiederholt und insbesondere kontinuierlich gemessen. Es wird also eine Abfolge von einzelnen Messschritten bₙ) durchgeführt, wobei der Takt dieser Messschritte bₙ) insbesondere an den Takt der einzelnen Druckschritte aᵢ) gekoppelt sein kann. Die Frequenz der Messung muss dabei jedoch nicht identisch mit der Druckfrequenz sein, sie kann beispielsweise ein ganzzahliges Vielfaches oder einen ganzzahligen Bruchteil der Druckfrequenz betragen.

Die einzelnen Messwerte für die rheologische Eigenschaft werden von dem Sensor 170 an eine kombinierte Modellierungs- und Auswerteeinheit 180 übertagen, wobei dieser Datenfluss hier mit d1 bezeichnet ist. In der Modellierungs- und Auswerteeinheit 180 wird ein rheologisches Modell M bereitgestellt, über welches ein günstiger Wert für wenigstens einen ausgewählten Druckparameter ermittelt wird. Bei dieser Ermittlung können neben der gemessenen rheologischen Eigenschaft weitere Eingangsparameter eine Rolle spielen, beispielsweise eine gemessene oder modellierte Umgebungstemperatur bzw. Luftfeuchtigkeit und/oder relevante Parameter der Vorrichtung wie Material bzw. Geometrie der Druckschablone 120 und/oder des Rakelkopfsystems 130. In jedem Fall wird mit diesem Modell M ein günstiger Wert für den ausgewählten Druckparameter ermittelt und dieser Wert wird zurück an den beweglichen Teil der Druckvorrichtung übertragen. Diese Übermittlung des günstigen Druckparameters ist hier mit d2 bezeichnet. Der Wert wird beispielsweise an das Rakelkopfsystem 130 übertragen, wo über eine hier nicht gesondert dargestellte Einstelleinheit eine Einstellung des Druckparameters auf den ermittelten günstigen Wert erfolgt. Auf diese Weise kann beim Bedrucken des nachfolgenden Substrats s ein angepasster und optimierter Druckparameter verwendet werden. Hierdurch kann allgemein die Qualität des Druckergebnisses verbessert werden und insbesondere können über die laufende Messung der rheologischen Eigenschaft und eine kontinuierliche Neu-Berechnung und Nachstellung des ausgewählten Druckparameters Qualitätseinbußen durch Schwankungen in den Umgebungsparametern vermieden oder zumindest abgemildert werden.

Gemäß einer optionalen Variante des Herstellungsverfahrens wird die Qualität des Druckergebnisses in einem nachfolgenden Prozessschritt überwacht, und es wird eine gemessene Kenngröße an die Druckvorrichtung 100 zurückübermittelt. Dies ist hier beispielhaft anhand der nachfolgenden optischen Inspektionsvorrichtung 200 gezeigt, welche insbesondere eine Lotpasteninspektionsvorrichtung sein kann. Diese Vorrichtung 200 weist einen Inspektionstisch 210 auf, auf welchem das jeweils zu inspizierende Substrat sⱼ während der Messung angeordnet wird. Über diesem Tisch 210 ist ein optisches Messsystem 220 angeordnet, mit welchem ein oder mehrere Qualitäts-Kenngrößen des Druckergebnisses gemessen werden können. Diese gemessenen Kenngrößen werden optional in einer Datenspeichervorrichtung 230 gespeichert und jedenfalls zurück an die Druckvorrichtung übermittelt. Dieser Datenfluss ist hier mit d3 bezeichnet. Auch die optische Messung dieser Kenngröße wird wiederholt durchgeführt und insbesondere für jedes zu prozessierende Substrat s im Anschluss an den Druckschritt ausgeführt. Durch die Rückübermittlung d3 der Daten wird ein geschlossener Regelkreis geschaffen, da die optischen Kenngrößen in dem rheologischen Modell M als zusätzlicher Input verwendet werden, um bei der nächsten Ermittlung eines günstigen Werts für den ausgewählten Druckparameter ein noch weiter verbesswertes Ergebnis zu liefern. Eine solche Anpassung kann entweder durch eine Änderung des Modellierungsverfahrens selbst und/oder durch eine Anpassung von Annahmen über weitere Parameter (wie z.B. Temperatur oder Feuchte) durchgeführt werden. In jedem Fall wird bei dieser besonders vorteilhaften Ausführungsvariante mit einem geschlossenen Regelkreis eine zusätzliche Optimierung des Druckparameters in Abhängigkeit von der tatsächlich erzielten Druckqualität erreicht, wobei innerhalb des Modells die laufend gemessene rheologische Eigenschaft berücksichtigt wird. Mit dem Modell können dann insbesondere auch zeitliche Variationen in der gemessenen rheologischen Eigenschaft mit zeitlichen Variationen in der erzielten Druckqualität korreliert werden, und unter Berücksichtigung dieser Korrelation kann eine noch weiter verbesserte kontinuierliche Anpassung des ausgewählten Druckparameters erreicht werden.

### Bezugszeichenliste

- 1: Fertigungsanlage
- 10: elektronische Baugruppe
- 20: Prozessrichtung
- 30: Fördervorrichtung
- 40: Einlaufstapler
- 50: Auslaufstapler
- 100: Druckvorrichtung
- 110: Drucktisch
- 120: Druckschablone
- 130: Druckkopf
- 140: Vorratsbehälter
- 150: Zuflussleitung
- 160: Druckmedium
- 170: Rheometer
- 180: Modellierungs- und Auswerteeinheit
- 200: Lotpasteninspektionsvorrichtung
- 210: Inspektionstisch
- 220: optisches Messsystem
- 230: Datenspeichervorrichtung
- d1: Übermittlung der rheologischen Messdaten
- d2: Übermittlung des günstigen Druckparameters
- d3: Übermittlung der optischen Messdaten
- M: rheologisches Modell
- s: Substrat
- sᵢ: Substrat mit Index i
- sⱼ: Substrat mit Index j

## Patentansprüche

1. Verfahren zum Herstellen von elektronischen Baugruppen (10), umfassend die folgenden Schritte:
a) strukturiertes Auftragen eines fluiden Druckmediums (160) mittels einer Druckvorrichtung (100),
- wobei Schritt a) in einer sequenziellen Abfolge von einzelnen Druckschritten aᵢ) mehrfach hintereinander durchgeführt wird,
b) Messung wenigstens einer rheologischen Eigenschaft des Druckmediums (160) innerhalb der Druckvorrichtung (100),
- wobei Schritt b) in einer wiederholten Abfolge von einzelnen Messschritten bₙ) während der einzelnen Druckschritte aᵢ) und/oder zwischen den einzelnen Druckschritten aᵢ) durchgeführt wird,
c) Bereitstellen eines rheologischen Modells (M) für den Ablauf der einzelnen Druckschritte aᵢ),
- wobei das rheologische Modell (M) die wiederholt gemessene rheologische Eigenschaft als variablen Eingangsparameter nutzt,
d) Ermitteln eines günstigen Wertes für wenigstens einen ausgewählten Druckparameter mit Hilfe des rheologischen Modells (M) in Abhängigkeit von der aktuell gemessenen rheologischen Eigenschaft,
e) automatisiertes Einstellen des ermittelten günstigen Wertes für den wenigstens einen ausgewählten Druckparameter.

2. Verfahren nach Anspruch 1, wobei bei der sequenziellen Abfolge von einzelnen Druckschritten aᵢ) eine Abfolge von mehreren einzelnen Substraten (s,sᵢ,sⱼ) bedruckt wird.

3. Verfahren nach Anspruch 2, bei welchem die einzelnen Substrate (s,sᵢ,sⱼ) elektrische Schaltungsträger sind.

4. Verfahren nach einem der vorhergehenden Ansprüche, bei welchem das fluide Druckmedium (160) eine Paste ist.

5. Verfahren nach einem der vorhergehenden Ansprüche, bei welchem das fluide Druckmedium (160) eine Lotpaste, eine Sinterpaste, ein Vergussmittel, ein Füllmittel oder ein Klebemittel ist.

6. Verfahren nach einem der vorhergehenden Ansprüche, insbesondere nach Anspruch 5, bei welchem das fluide Druckmedium (160) metallische Partikel und zusätzlich ein flüssiges Bindemittel und/oder einen Aktivator enthält.

7. Verfahren nach einem der vorhergehenden Ansprüche, bei welchem die Druckvorrichtung (100) ein Schablonendrucker, ein Siebdrucker, ein Tampondrucker oder ein Dispenser ist.

8. Verfahren nach einem der vorhergehenden Ansprüche, bei welchem der wenigstens eine ausgewählte Druckparameter eine Rakelgeschwindigkeit, eine Rakelkraft oder ein Absprung ist.

9. Verfahren nach einem der vorhergehenden Ansprüche, bei welchem die in den einzelnen Messschritten bₙ) gemessene rheologische Eigenschaft eine Viskosität, eine Schubspannung, ein Verlustmodul und/oder ein Speichermodul ist.

10. Verfahren nach einem der vorhergehenden Ansprüche, bei welchem die rheologische Eigenschaft mit einem in die Druckvorrichtung (100) integrierten Prozessrheometer (170) gemessen wird.

11. Verfahren nach einem der vorhergehenden Ansprüche, bei welchem die Schritte d) und e) mehrfach wiederholt werden.

12. Verfahren nach einem der vorhergehenden Ansprüche, bei welchem die Ermittlung eines günstigen Wertes in Schritt d) derart erfolgt, dass eine mit Hilfe des rheologischen Modells (M) vorhergesagte Zielgröße optimiert wird.

13. Verfahren nach einem der vorhergehenden Ansprüche, bei welchem das in Schritt c) bereitgestellte rheologische Modell (M) laufend angepasst wird, indem im Anschluss an die einzelnen Druckschritte aᵢ) jeweils eine Zielgröße für das Druckergebnis gemessen wird und mit der entsprechenden mit Hilfe des rheologischen Modells (M) vorhergesagten Zielgröße verglichen wird.

14. Verfahren nach einem der Ansprüche 12 oder 13, bei welchem die modellierte und/oder gemessene Zielgröße die Genauigkeit der Einhaltung einer vordefinierten zu bedruckenden Benetzungsfläche ist.

15. Fertigungsanlage (1) zum Herstellen von elektronischen Baugruppen (10), welche dazu ausgelegt ist, ein Verfahren nach einem der Ansprüche 1 bis 14 durchzuführen,
umfassend eine Druckvorrichtung (100) mit
- einem Druckbereich (110) zur Aufnahme eines oder mehrerer Substrate (s,sᵢ,sⱼ), welcher ausgebildet ist, eine Abfolge von mehreren zu bedruckenden Druckflächen sequenziell bereitzustellen,
- einem Druckkopf (130) zum Auftragen des Druckmediums (160),
- und einem rheologischen Sensor (170) zu Messung der wenigstens einen rheologischen Eigenschaft des Druckmediums (160) innerhalb der Druckvorrichtung (100),
und ferner umfassend
- eine Modellierungseinheit (180), welche dazu ausgelegt ist, ein rheologisches Modell (M) für den Ablauf der einzelnen Druckschritte aᵢ) bereitzustellen, wobei das rheologische Modell (M) die wiederholt gemessene rheologische Eigenschaft als variablen Eingangsparameter nutzt,
- eine Auswerteeinheit (180), um mit Hilfe des rheologischen Modells (M) in Abhängigkeit von der aktuell gemessenen rheologischen Eigenschaft einen günstigen Wert für wenigstens einen ausgewählten Druckparameter zu ermitteln
- und eine Einstelleinheit, um den ermittelten günstigen Wert für den wenigstens einen ausgewählten Druckparameter automatisiert einzustellen.
